# EUROPÄISCHE PATENTANMELDUNG

(11) **EP 4 287 281 A1**
(43) Veröffentlichungstag der Anmeldung: **06.12.2023**
(21) Anmeldenummer: 22020256.8
(22) Anmeldetag: 01.06.2022
(51) Int. Cl.: H01L 39/00, H01L 29/205

(54) **WIDERSTANDSARMER ELEKTRONENTRANSPORT IN FESTKÖRPERN**

(71) Anmelder: ANDRÄ, Jürgen, 38700 Corenc (FR)
(72) Erfinder: ANDRÄ, Jürgen, 38700 Corenc (FR)

(57) **Zusammenfassung**

Widerstandsarme elektrische Stromleitung bei Temperaturen bis über Zimmertemperatur lässt sich möglicherweise dadurch erzielen, dass Elektronen sehr hoher Beweglichkeit in einem von der Grundzustandsenergie E₀ bis zu einer Grenzenergie E_{G}>E₀ gefüllten Leitungsband eines Festkörpers einem Magnetfeld in z-Richtung (B_{z}) und einem elektrischen Feld in y-Richtung (E_{y}) ausgesetzt werden, was aufgrund ihrer Zyklotron-Bewegung in der x-y-Ebene trotz ihrer Energie zwischen E₀ und E<(E_{G}-kT) im Leitungsband zu einem Zyklotron-Driftstrom dieser Elektronen in x-Richtung führt, der widerstandlos ist, da er weder durch Beschleunigung der Elektronen in einem elektrischen Feld noch durch Streuung der Elektronen an Fehlstellen, Verunreinigungen oder Phononen gestört wird, da alle möglichen Endzustände dieser Prozesse besetzt sind. Die dazu notwendige hohe Beweglichkeit (µ) der Elektronen könnte eventuell in Festkörper-Heterostrukturen mit zweidimensionalen Elektronengasen (2DEG) erreicht werden.

## Beschreibung

Herkömmliche elektronische Festkörper-Bauelemente und elektrische Leiter leiden wegen elektrischer Widerstände unter elektrischen und thermischen Verlusten. Die vorliegende Erfindung betrifft die Reduktion dieser elektrischen Widerstände und damit dieser Verluste elektronischer Leitung in Festkörpern und die verlustarme elektrische Stromerzeugung in Festkörpern bei Temperaturen bis über Zimmertemperatur.

Die elektrische Leitung durch Elektronen eines gefüllten Leitungsbandes eines Festkörpers (Metalls) ist bekannt. Dabei werden Elektronen mit Energien im Bereich der thermisch aufgeweichten Fermi-Kante E_{F}±kT (k=Boltzmann-Konstante, T=Temperatur) im angelegten elektrischen Feld in x-Richtung Eₓ in angeregte, vorher unbesetzte Energiezustände beschleunigt. Durch Streuung an Ionen, Kristall-Fehlstellen, Verunreinigungen oder Phononen wird diese Elektronen-Beschleunigung gebremst, was als elektrischer Widerstand zu beobachten ist. Alle Elektronen des Leitungsbandes mit Energien im Bereich vom Grundzustand E₀ bis etwa E_{F}-kT können nicht an der elektrischen Leitung teilnehmen, da für diese Elektronen alle Endzustände eines Beschleunigungsprozesses besetzt sind.

Letztere Beschränkung kann mit oder ohne Eₓ durch Anlegen eines Magnetfeldes aufgehoben werden, denn ein Elektron führt in einem Magnetfeld in z-Richtung B_{z} eine kreisförmige Zyklotron-Bewegung in der x-y-Ebene mit dem Flächenbedarf von S=h/(e·B_{z}) (siehe Ref.[1]) und der Frequenz *v*=eB_{z}/(2πm^{∗}ₑ) aus, wobei e seine elektrische Ladung, h das Plancksche Wirkungsquantum und m^{∗}ₑ seine effektive Masse im entsprechenden Material sind. Wird dieses rotierende Elektron einem zusätzlichen elektrischen Feld in y-Richtung E_{y} ausgesetzt, erfährt es eine Zyklotron-Driftbewegung in x-Richtung mit der Geschwindigkeit vₓ= E_{y}/B_{z}. Die Frequenz und die Zyklotron-Driftgeschwindigkeit sind unabhängig von der Energie des Elektrons.

In einem elektrisch leitenden Festkörper können Elektronen im obigen Sinn nur dann eine Zyklotron-Driftbewegung durchführen, wenn ihre Beweglichkeit µ=eτ/mₑ^{∗}[m²/Vs] groß genug wird, um den Elektronen mehrere Zyklotron-Perioden P=l/v in der mittleren freien Flugzeit τ zu ermöglichen. Die geschätzte Bedingung τ≥10·P liefert dann µ≥20π/B_{z} [m²/Vs], wobei B_{z} in der Einheit Tesla [Vs/m²] einzusetzen ist. Je grösser also B_{z} gemacht werden kann, desto geringer werden die Anforderung an µ und S.

Wenn Elektronen, die diese Bedingung erfüllen, gekreuzten Feldern B_{z} und E_{y} ausgesetzt werden und alle Energie-Zustände des Leitungsbands von der Grundzustandsenergie E₀ bis zu einer Grenzenergie E_{G}-kT vollständig und darüber hinaus die Energie-Zustände von E_{G}-kT bis E_{G}+kT immer weniger besetzt sind, dann sind sie alle unabhängig von ihrer Energie an der vₓ-Zyklotron-Driftbewegung beteiligt. Wird in einer Festkörper-Probe der Länge Lₓ, der Breite L_{y}<Lₓ und der Dicke L_{z} mit einem solchen Leitungsband das Feld E_{y}=U_{y}/L_{y} in y-Richtung durch eine Spannungsdifferenz U_{y} erzeugt, dann fließt bei einer Flächen-Elektronendichte von ρ_{s[}m⁻²] ein Zyklotron-Driftstrom Jₓ=ρₛeU_{y}/B_{z} [A]. Zu diesem Strom Jₓ tragen alle im Leitungsband befindlichen Elektronen von E₀ bis E_{G}+kT bei. Für (E_{G}-E₀)>kT sind alle Energiezustände unterhalb E_{G}-kT vollständig besetzt. Dadurch können alle Elektronen des Leitungsbandes mit Energien E < E_{G}-kT, die an der Zyklotron-Driftbewegung teilnehmen, weder thermisch angeregt noch an Ionen, Fehlstellen, Verunreinigungen oder Phononen gestreut werden, da alle möglichen Endzustände dieser Prozesse besetzt sind. Der Strom der Zyklotron-Driftbewegung der Elektronen in diesem energetischen Bereich des Leitungsbandes erleidet also keinerlei elektrischen Widerstand. Die bisher beste und kompletteste Beschreibung sowohl des ganzzahligen als auch des fraktionierten Quanten Hall Effekts [2,3] bestätigen diesen Befund.

Festkörper mit vollständig bis E_{G} gefülltem Leitungsband, das (E_{G}-E₀)>kT und µ≥20π/B_{z} erfüllt, existieren bei Zimmertemperatur leider nicht in der Natur für Magnetfelder B_{z} ≤ 1 Tesla. Ein solches Leitungsband mit Elektronen sehr hoher Beweglichkeit lässt sich aber zum Beispiel mit MBE (Molecular Beam Epitaxie) [4] oder ähnlichen Techniken künstlich als zweidimensionales Elektronengas (2DEG) in Halbleiter-Heterostrukturen erzeugen. Solche 2DEG spielen heute eine große Rolle in MOSFETs (Metal Oxide Semiconductor Field Effect Transistor, siehe Abb.19.36 in Ref.[5]) oder HEMTs (High Electron Mobility Transistoren, siehe Bild 5.54 in Ref.[6]), in anderen elektronischen Bausteinen, und werden bis zu extrem hohen Beweglichkeiten µ=4400 m²/Vs [4,7] in der Quanten-Hall-Forschung verfeinert.

Wie in Fig.1 der Ref.[2] oder Abb.10.33 der Ref.[5] erläutert, bildet sich dabei in z-Richtung an der Grenzfläche zwischen zwei Halbleitern I und II (zum Beispiel I=AlₓGa₁₋ₓAs, x<0.2 und II=GaAs) ein dreiecksförmiger, mit Elektronen gefüllter Potentialtrog geringer z-Ausdehnung aus, der nur die z-Grundzustands-Wellenfunktion mit der Energie E₀ zulässt. Dieser Quantentrog ist mit konstanter Energiedichte eines 2DEG von der Energie E₀ bis zur Fermi-Energie E_{G} = E_{F} der Heterostruktur mit Elektronen gefüllt. Für das genannte Beispiel ist die Tiefe E_{G}-E₀=E_{G0} des Quantentrogs von der Grössenordnung kT bei Zimmertemperatur. Deshalb mussten für die Quanten-Hall-Experimente [2,3] Temperaturen T ≤ 100 mK gewählt werden, damit der Bruchteil R = (E_{G0}-kT)/E_{G0} aller Elektronen, das heisst praktisch alle Elektronen im 2DEG am verlustfreien Zyklotron-Driftstrom Jₓ teilnehmen können. Dies war notwendig, um die wissenschaftlich und metrologisch interessanten Strukturen der Quanten-Hall-Effekte zu beobachten. Bei höheren Temperaturen wird über diese Strukturen gemittelt, der verlustfreie Zyklotron-Driftstrom Jₓ bleibt aber für den Bruchteil R aller Elektronen im 2DEG erhalten. Für technische Anwendungen ist es also notwendig, das Verhältnis E_{G0}/kT ≥1 zu machen, um bei gegebener Temperatur T vom verlustfreien Zyklotron-Driftstrom Jₓ profitieren zu können. Dazu geeignete Verfahren sind zum Beispiel das Anlegen einer Gate-Spannung an einem HEMT, die auf direkte Weise E_{G0} variiert, oder die massive Dotierung der AlₓGa₁₋ₓAs-2DEG-Randschicht, die bei der Produktion des 2DEG dessen Quantentrog-Tiefe E_{G0} erhöht, oder die Modulations-Dotierung des 2DEG (Einführen einer oder mehrerer in z-Richtung entfernter Dotierungs-Schichten mit Donator-Energien E_{D}<E₀, siehe Fig.5 der Ref. [2]), die mit Infrarot-Strahlung die Konditionierung der Tiefe von E_{G0} ermöglicht. Bei diesen Betrachtungen spielt es keine Rolle, dass bei Vergrösserung von E_{G0} auch höhere z-Energiezustände Eₙ des 2DEG als E₀ besetzt werden.

Für alle Temperaturen, für die mit diesen oder ähnlichen Verfahren E_{G0}>kT erreicht wird, kann dann der Bruchteil R = (E_{G0}-kT)/E_{G0} aller Elektronen im 2DEG am verlustfreien Zyklotron-Driftstrom Jₓ teilnehmen, der ab hier Superstrom genannt wird. Dieser Superstrom kann selbst bei Zimmertemperatur durch grosses E_{G0}/kT dominant gemacht werden, wobei ein elektrischer Restwiderstand nur von den Elektronen mit Energien von E_{G}-kT bis E_{G}+kT erzeugt wird. Das Verhältnis der Elektronen, die den Superstrom erzeugen, zu den Elektronen, die den Restwiderstand bewirken, wird dann S = (E_{G0}-kT)/kT. Ab einem Verhältnis S≥1 wird der Superstrom dominant. Diese Dominanz kann durch tiefere Temperaturen wie zum Beispiel bei Flüssigluft-Temperaturen deutlich gesteigert werden.

Als weitere Beispiele für die Erzeugung von 2DEG für Elektronen sehr hoher Beweglichkeit mit S>1 lassen sich durch verschiedene Schichtung von Festkörperfilmen ähnliche Quantentröge oder von drei Halbleitern in der Folge I-II-I auch rechteckförmige Quantentröge oder sogar rechteckförmige Quantentrog-Übergitter mit wiederholten Folgen der Halbleiter I-II-I-II-I-II-I- usw. erzeugen. Mit einer I-II-I Heterostruktur, die durch Modulations-Dotierung erweitert ist (siehe Fig.2b in Ref.[7]), wird beispielsweise ein rechteckförmiger Quantentrog von 30 nm Höhe und einer Flächen-Elektronendichte ρₛ von 2·10¹⁵ m⁻2 bei den oben genannten µ=4400 m²/Vs erhalten, der widerstandlose Superströme im mA-Bereich zulässt.

Wenn die 2DEG mit E_{G0}>kT und µ≥20π/B_{z} einem äusseren Magnetfeld B_{z} ausgesetzt oder in intrinsische, der Fläche LₓxL_{y} des 2DEG angepassten Magnetfelderzeugung eingebettet werden, können verlustarme Superstrom-Bauelemente der Elektronik und Mikroelektronik bei Temperaturen bis über Zimmertemperatur bereitgestellt werden, deren Superströme bei konstantem Magnetfeld durch die Spannung U_{y} oder durch die oben beschriebene Gate-Spannung HEMT-ähnlicher Heterostrukturen gesteuert werden können. Der entscheidende Vorteil der Erfindung ist also die Reduktion elektrischer und thermischer Verluste dieser Superstrom-Bauelemente gegenüber herkömmlichen Bauelementen der Elektronik. Durch Serienschaltung solcher Bauelemente lassen sich verlustarme Superstromleiter bei Zimmertemperatur herstellen. Solche Bauelemente können auch als Spannungs-Superstrom-Konverter oder als spannungsgesteuerte Superstromquellen betrieben werden. Weitere Anwendungen sind zu erwarten.

Als Nachteil der Erfindung muss der Flächenbedarf S pro Elektron bewertet werden, der eine Miniaturisierungs-Grenze für die Breite L_{y}>10√S der 2DEG setzt. Für beispielsweise B_{z}=1 Tesla wird eine Breite des 2DEG von etwa 0,6 µm benötigt.

Die Beschränkung auf 2DEG kann aufgehoben werden, wenn Festkörper-Kombinationen, -Legierungen und/oder -Dotierungen mit einer ElektronenBeweglichkeit µ>2π/B_{z} gefunden werden. Es genügt dann, dass ein Bruchteil der im Leitungsband dieses Materials befindlichen Elektronen keine Beschleunigung durch ein Eₓ-Feld und keine Streuung an Ionen, Fehlstellen, Verunreinigungen oder Phononen erfahren können, da alle möglichen Endzustände dieser Prozesse für diese Elektronen besetzt sind. Dieser Bruchteil der Elektronen im Leitungsband kann dann bei Anlegen der B_{z}- und E_{y}-Felder einen Superstrom liefern, der den elektrischen Gesamtwiderstand dieses Materials reduziert.

Die Erfindung wurde zwar anhand ihrer bevorzugten Ausführungsformen erläutert, doch es können viele weitere Änderungen und Variationen vorgenommen werden, ohne über den Umfang der vorliegenden Erfindung hinauszugehen. Daher ist es vorgesehen, dass die beiliegenden Patentansprüche Änderungen und Variationen abdecken, die im tatsächlichen Umfang der Erfindung enthalten sind.

### Referenzen

[1] L. Landau, Z.Phys.64, 629 (1930)
[2] H.J. Andrä, "The Plateaus of the Quantum Hall Effects", DOI: 10.13140/RG.2.2.17807.82085, June 2020
[3] H.J. Andrä, "The Integer and Fractional Quantum Hall Effects and the transition between them", wird einige Tage nach Einreichung dieser Patentanmeldung auf der "homepage" Horst Jürgen Andrä bei Researchgate veröffentlicht.
[4] V. Umansky et al., "MBE growth of ultra-low disorder 2DEG with mobility exceeding 35×106 cm2/Vs", J. Crystal Growth 311,1658 (2009)
[5] R. Gross und A. Marx, "Festkörperphysik", Oldenbourg Verlag, 2012, ISBN 978-3-486-712294-0
[6] A. Möschwitzer, "Grundlagen der Halbleiter- & Mikroelektronik, Bd.1 ", Carl Hanser Verlag München, 1992, ISBN 3-446-16456-1
[7] Y.J. Chung et al., « Ultra-high-quality two-dimensional electron systems », Nature Materials 20, 632 (2021)

## Patentansprüche

1. Widerstandsarme bis widerstandslose elektrische Stromleitung bei Temperaturen bis über Zimmertemperatur, **dadurch gekennzeichnet, dass** ein Bruchteil der im Leitungsband eines Festkörpers befindlichen Elektronen hoher Beweglichkeit µ>2π/B_{z} m²/Vs keine Beschleunigung durch ein elektrisches Feld und keine Streuung an Ionen, Fehlstellen, Verunreinigungen oder Phononen erfahren können, da alle möglichen Endzustände dieser Prozesse für diese Elektronen besetzt sind, so dass dieser Bruchteil der Elektronen bei Anlegen gekreuzter magnetischer B_{z}-Felder in z-Richtung und elektrischer E_{y}-Felder in y-Richtung einen widerstandslosen Zyklotron-Driftstrom in x-Richtung liefern, der den elektrischen Gesamtwiderstand dieses Festkörpers reduziert.

2. Anspruch nach Anspruch 1, **dadurch gekennzeichnet, dass** Elektronen hoher Beweglichkeit alle Energiezustände von der Grundzustandsenergie E₀ bis zur Grenz-Energie E_{G}>E₀ des Leitungsbandes eines Festkörpers besetzen sowohl einem Magnetfeld in z-Richtung B_{z} als auch einem elektrischen Feld in y-Richtung E_{y} ausgesetzt werden, was aufgrund ihrer Zyklotron-Bewegung in B_{z} trotz ihrer Energie zwischen E₀ und E_{G}-kT im Leitungsband zu einem Zyklotron-Driftstrom dieser Elektronen in x-Richtung führt, der widerstandlos ist, da er weder durch thermische Anregungen der Elektronen noch durch Streuung der Elektronen an Fehlstellen, Verunreinigungen oder Phononen gestört wird, da alle möglichen Endzustände dieser Prozesse besetzt sind.

3. Anspruch nach Ansprüchen 1 und 2, **dadurch gekennzeichnet, dass** Festkörper-Strukturen mit MBE (Molecular Beam Epitaxie) oder ähnlichen Techniken produziert werden, die vollständig gefüllte Leitungsbänder für Elektronen hoher Beweglichkeit µ>2π/B_{z} mit Energien zwischen E₀ und E_{G} mit der Eigenschaft (E_{G}-E₀)>kT ermöglichen.

4. Anspruch nach Ansprüchen 1 bis 3, **dadurch gekennzeichnet, dass** allgemein Festkörper-Strukturen oder speziell Halbleiter-Heterostrukturen mit Quantentrögen produziert werden, die 2DEG (zweidimensionale Elektronengase) in der x-y-Ebene mit beispielsweise der Länge Lₓ und der Breite L_{y} mit den in Ansprüchen 1 bis 3 genannten Eigenschaften ermöglichen, wobei durch beidseitig bei ±L_{y}/2 angebrachte Elektroden und die Spannungsdifferenz U_{y} zwischen diesen beiden Elektroden das elektrischen Feld E_{y} im 2DEG erzeugt werden kann.

5. Anspruch nach Ansprüchen 1 bis 4, **dadurch gekennzeichnet, dass** Festkörper-Strukturen durch Schichtung von Filmen verschiedener Materialien so produziert werden, dass verschiedene Quantentrog-Formen für 2DEG erzeugt werden können oder Serien von Quantentrögen für Serien von 2DEG in den drei Raumrichtungen möglich werden.

6. Anspruch nach Ansprüchen 1 bis 5, **dadurch gekennzeichnet, dass** die Quantentrog-Tiefe E_{G0}=E_{G}-E₀ durch verschiedene Verfahren wie zum Beispiel mit der Gate-Spannung an einem HEMT, mit speziellen Dotierungskonzepten und/oder mit Infrarot-Strahlung so konditioniert wird, dass E_{G0} grösser als kT bei Zimmertemperatur erreicht wird, damit mehr als die Hälfte der Elektronen im 2DEG am verlustfreien Zyklotron-Driftstrom Jₓ teilnehmen kann.

7. Anspruch nach Ansprüchen 1 bis 6, **dadurch gekennzeichnet, dass** die so in der x-y-Ebene produzierten 2DEG einem nicht unbedingt homogenen Magnetfeld in z-Richtung B_{z} über die ganze Fläche LₓxL_{y} der 2DEG ausgesetzt werden, das beispielsweise durch äussere Permanentmagnete oder durch intrinsische, der Fläche LₓxL_{y} des 2DEG angepassten Magnetstrukturen erzeugt wird, wobei letztere beispielsweise aus Mikro-Permanentmagneten, aus permanentmagnetischen Schichten in nächstmöglicher Nachbarschaft der 2DEG oder aus der Dotierung einiger der die 2DEG definierenden Schichten mit magnetisierbaren Nanopartikeln (Atomen) bestehen können, mit denen lokal sehr hohe Magnetfelder B_{z} erreicht werden können.

8. Anspruch nach Ansprüchen 1 bis 7, **dadurch gekennzeichnet, dass** MOSFET (Metal Oxide Semiconductor Field Effect Transistor, siehe Abb.10.36 in Ref.[5])- oder HEMT (High Electron Mobility Transistor, siehe Bild 5.54 in Ref.[6])-ähnliche Festkörper-Strukturen mit 2DEG in der x-y-Ebene inklusive B_{z}-Erzeugung produziert werden, bei denen über die Breite L_{y} des 2DEG durch entsprechende Elektroden die Spannung U_{y} für die Erzeugung des elektrischen Feldes E_{y}=U_{y}/L_{y} im 2DEG angelegt werden kann, damit durch Wirken des Magnetfeldes in z-Richtung B_{z} der Superstrom aller Elektronen des 2DEG in x-Richtung an der "drain"-Elektrode abgegriffen werden kann, der sich mit der Gate-Spannung und/oder mit U_{y} steuern lässt.

9. Anspruch nach Ansprüchen 1 bis 8, **dadurch gekennzeichnet, dass** MOSFET- oder HEMT-ähnliche Festkörper-Strukturen durch mehrere Dünnschichtfilme so ergänzt werden (siehe als Beispiel Fig.2b der Ref.[7]), dass 2DEG inklusive B_{z}-Erzeugung mit grösst-möglicher Beweglichkeit µ der Elektronen und E_{G0}>kT in Superstrom leitenden oder Superstrom produzierenden, elektronischen Bauelementen verwirklicht werden, die eventuell durch Infrarotstrahlung konditioniert werden können.

10. Anspruch nach Ansprüchen 1 bis 9, **dadurch gekennzeichnet, dass** solche elektronischen Bauelemente in Serie geschaltet einen Superstrom-Leiter oder parallel geschaltet einen Superstromerzeuger liefern.

11. Anspruch nach Ansprüchen 1 bis 9, **dadurch gekennzeichnet, dass** 2DEG mit µ>2π/B_{z}, E_{G0}>kT und B_{z}-Erzeugung, in grosser Länge Lₓ in einem Elektronik-Bauelement als spannungsgesteuerter Superstromleiter hergestellt wird.

12. Anspruch nach Ansprüchen 1 bis 9, **dadurch gekennzeichnet, dass** integrierte Parallelschaltungen vieler 2DEG mit µ>2π/B_{z}, E_{G0}>kT und B_{z}-Erzeugung in einem Elektronik-Bauelement als spannungsgesteuerter Superstromgenerator hergestellt wird.

13. Anspruch nach Ansprüchen 1 bis 12, **dadurch gekennzeichnet, dass** 2DEG-Mikrostrukturen mit µ>2π/B_{z}, E_{G0}>kT und B_{z}-Erzeugung in integrierte Schaltungen eingebaut und damit deren thermische Verluste deutlich reduziert werden.

14. Anspruch nach Ansprüchen 1 bis 13, **dadurch gekennzeichnet, dass** alle bisher genannten elektronischen Bauelemente bei tieferen Temperaturen als Zimmertemperatur betrieben werden, was die Bedingung E_{G0}>kT verbessert.
